(19)

**Europäisches Patentamt**

**European Patent Office**

**Office européen des brevets**

(11)　**EP 3 907 869 A1**

(12)　# EUROPEAN PATENT APPLICATION

(43) Date of publication:
**10.11.2021 Bulletin 2021/45**

(21) Application number: **20305434.1**

(22) Date of filing: **04.05.2020**

(51) Int Cl.:
*H02M 1/08* [(2006.01)]　　*H02M 1/088* [(2006.01)]
*H03K 17/16* [(2006.01)]　　*H03K 17/042* [(2006.01)]
*H02M 1/00* [(2006.01)]　　*G01R 15/18* [(2006.01)]
*H01F 5/00* [(2006.01)]

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **Mitsubishi Electric R&D Centre Europe B.V.
1119 NS  Schiphol Rijk Amsterdam (NL)**
Designated Contracting States:
**FR**
• **Mitsubishi Electric Corporation
Tokyo 100-8310 (JP)**
Designated Contracting States:
**AL AT BE BG CH CY CZ DE DK EE ES FI GB GR
HR HU IE IS IT LI LT LU LV MC MK MT NL NO PL
PT RO RS SE SI SK SM TR**

(72) Inventors:
• **LE LESLE, Johan
35708 RENNES Cedex 7 (FR)**
• **MORAND, Julien
35708 RENNES Cedex 7 (FR)**
• **MOLLOV, Stefan
35708 RENNES Cedex 7 (FR)**

(74) Representative: **Plasseraud IP
66, rue de la Chaussée d'Antin
75440 Paris Cedex 09 (FR)**

(54)　**CONTROL PROCESS AND SYSTEM FOR POWER CONVERTER AND POWER CONVERTER
COMPRISING SUCH A CONTROL PROCESS AND SYSTEM**

(57)　Switching method for a half bridge power converter comprising at least a pair of power switches in a leg of said converter providing an upper branch power switch and a lower branch power switch and comprising a first gate control circuit (12) for said upper branch power switch and a second gate control circuit (13) for said lower branch power switch, characterized in that said switching method comprises:
- sensing the current derivative in said upper branch and the current derivative in said lower branch during switching of said pair of power switches to provide a first signal $\left(\dfrac{dI_u(t)}{dt}\right)$ proportional to the current derivative of the power current in said upper power switch and a second signal $\left(\dfrac{dI_l(t)}{dt}\right)$ proportional to the current derivative of the power current in said lower power switch,

- summing said first and second signals to provide a summed current derivative signal $\left(\dfrac{dI(t)}{dt}\right)$ and;
- adding said summed current derivative signal (18a) to the power switch command signal (16a) of said first gate control circuit (12) and the power switch command signal of said second gate control circuit (13) causing the summed derivative signal to modulate the gate commutation signals (17a) of said gate control circuits such that the current variation in both power switches is equalized by slowing down the commutation of a first power switch of said pair of power switches while accelerating the commutation of the other switch of said pair of power switches.

EP 3 907 869 A1

**FIG. 2**

**Description**

**Field of the invention**

The present disclosure concerns power converters composed of at least one half bridge comprising two switches driven in a complementary way from blocking to conducting and conducting to blocking and proposes an improved control process and system that eliminates dead-times between commutations of the two switches.

**Background**

In power converters, between transitions of switches, dead-times where both switches are OFF, are used. The main reason of such dead-times is to avoid the risk of overlapping of the control voltage due to multiple factors including propagation delay, mismatch between turn-on and turn-off, drifting of the threshold voltage over the temperature and so on, leading to shoot-through current which could damage the devices. To avoid this and to assure current continuity during dead-time either freewheeling diodes, intrinsic reverse capability of the switch devices such as body diode in case of a MOSFET or the third quadrant conduction capability of a lateral Gallium Nitride (GaN) device are used.

Although absolutely necessary, the reverse conduction phase during dead-times is the cause of disadvantages in the converter operation. To reduce the component number and the associated cost, some power modules are not equipped with antiparallel diode and rely on the reverse capability of the switch. However, the switching performance or the conduction performance of this intrinsic diode is often strongly lower than the ones of an external diode especially, Schottky barrier diodes. Thus, the dead-time operation time has a significant impact on the losses of the converter. An additional issue is that it is not possible to adjust a dead-time that will always ensure no diode conduction.

In addition, some distortion is also induced in the control loops due to the nonlinearity related to dead-time. Smart control methods can be implemented to reduce the dead-time according to the operation point, by using a look-up table. The reverse conduction time is then limited as much as possible. Meanwhile fast computation capabilities are required, usually more expensive. Even if dead-time duration is optimized it is still present.

A fast and precise control of the two switches is necessary in a power converter. Due to fast switching capabilities of Wide Band Gap devices (WBG) such as Silicon Carbide (SiC) or GaN, an increase in the switching frequency increases the constraints on the control.

The commonly implemented half-bridge configurations require a dead-time avoiding cross-conduction and shoot-through current which can lead to significant additional losses or even the destruction of the semiconductors if not properly controlled.

During the dead-time/freewheeling transition one of the semiconductor device can carry the current in reverse conduction mode. However, high losses may be generated during the reverse conduction mode, mainly due to the poor characteristic of the body-diode, e.g. high forward voltage, reverse recovery charge [4].

To mitigate the losses issue, an antiparallel diode (e.g. SiC Schottky Barrier Diode) with better performance (lower voltage drop and zero recovery charge) can be added to operate during the dead-time. However, this is a costly solution which generally leads to bigger systems (two components instead of one) and additional stray inductance due to complementary wiring and even if the reverse recovery issue is alleviated there is still additional loss due capacitive charge.

**Problem addressed by the invention**

The invention of the present disclosure aims to reduce the dead-time duration and to prevent the use of additional fast and expensive diodes and counteracts the apparition of shoot-through current in a cost effective way.

**Summary of the invention**

An objective of the present disclosure is to replace the dead-time and reverse conduction of power semiconductors by a time period during which the two switches of a half bridge commutation cell are both conducting the current of the load with adjusted control signals. To achieve this, the shoot-through current during the transition is controlled by modulating the gate-voltage of the two switch devices in parallel. The control is based on sensors sensing the current derivative in such devices. The combination of the output of these sensors is amplified to control the gate voltage enabling a smooth commutation without reverse conduction of any device.

More precisely, the present disclosure proposes a switching method for a half bridge power converter comprising at least a pair of power switches in a leg of said converter providing an upper branch power switch and a lower branch power switch and comprising a first gate control circuit for said upper branch power switch and a second gate control circuit for said lower branch power switch, characterized in that said switching method comprises:

- sensing a current derivative in said upper branch and a current derivative in said lower branch during switching of said pair of power switches to provide a first signal $\left(\frac{dI_u(t)}{dt}\right)$ proportional to the current derivative of a power current in said upper power switch and a second signal $\left(\frac{dI_l(t)}{dt}\right)$ proportional to the current derivative of a power current in said lower power switch,

- summing said first and second signals to provide a summed current derivative signal $\left(\frac{dI(t)}{dt}\right)$ and;
- adding said summed current derivative signal to a power switch command signal of said first gate control circuit and a power switch command signal of said second gate control circuit causing the summed derivative signal to modulate gate commutation signals of said gate control circuits such that a current variation in both power switches is equalized by slowing down a commutation of a faster power switch of said pair of power switches while accelerating a commutation of a slower switch of said pair of power switches.

This method allows reducing of the commutation dead time and allows controlling current overshoot in such commutation.

In realization modes:
The method may comprise amplifying said summed current derivative signal prior to adding said summed current derivative signal to the power switch command signals.

Sensing the current derivative in said upper branch may be done with separate first and second upper sensors and sensing the current derivative in said lower branch may be done with separate first and second lower sensors to provide a first summed current derivative signal to be added to the switch command signal of said first gate control circuit and a second summed current derivative signal to be added to the switch command signal of said second gate control circuit.

This permits to have the sensors of the command circuits of the branches isolated from each other.

Said method may comprise referencing said first summed current derivative to the voltage of the bottom end of said upper branch power switch and referencing said second summed current derivative to the voltage of the bottom end of said lower branch power switch. The upper branch command circuit having a floating power supply is required as the source of the Mosfet switch or the emitter of a bipolar switch of the upper branch is at a variable voltage dependent of the switching state.

The present invention also concerns a half bridge power converter comprising an upper power switch on an upper branch of the converter, said upper power switch being driven by a first gate-control driver, and a lower power switch on a lower branch of the converter, said lower power switch being driven by a second gate-control driver, where said gate control drivers each comprises an electronic circuit for implementing the switching method of the present disclosure wherein said electronic circuits comprise, for each of said upper and lower switch, at least a first current derivative sensor on said upper branch providing a first current derivation signal, at least a second current derivative sensor on said lower branch providing a second current derivation signal, a modulating and conditioning circuit for adding and amplifying said first and second current derivation signals to provide an amplified summed derivation signal and an adder for adding said derivation signal to the command signals of said first and second gates drivers.

Such a configuration provides a closed-loop control of the switches during commutation which does not influence the on or off state of the switches outside the commutations.

Said modulating and conditioning circuits may be powered through power supplies having a mid-point referenced to the low end voltage of the power switch they act on.

This provides independent power supplies for each circuit.

Each of said modulating and conditioning circuits is located before a gate buffer and after a pre-driver circuit part of the gate-control driver of each of the power switches.

Said current derivative sensors may be made with Rogowski coils.

Rogowski coils are isolated from the branch conductors and provide an adequate signal of the sensed current derivatives.

Said Rogowski coils may be annular Rogowski coils located around power conductors of the power switches.

Said Rogowski coils are each routed with lines in multiple layers of a multilayer PCB having a central aperture for receiving a power conductor in a direction perpendicular to said PCB.

In a particular embodiment, two Rogowski coils may be interleaved on the upper branch power switch power conductor and/or on the lower branch power switch power conductor.

This improves the accuracy of the two sensors placed on the upper branch power switch power conductor and the lower branch power switch power conductor.

In a specific embodiment, said current derivative sensors may be straight Rogowski coils each routed in multiple layers of a multilayer PCB and surrounded by a power conductor track routed from an upper side to a lower side of said PCB around said planar coils in a perpendicular direction to said coils.

Such an embodiment is useful to reduce wiring and provide more compact circuitry.

Two straight Rogowski coils may be interleaved on the power conductor of the upper branch power switch and/or the power conductor of the lower branch power switch are interleaved.

The invention also applies to converters having several half bridge converters as disclosed.


## Brief description of the drawings

A detailed description of exemplary embodiments of the invention will be discussed hereunder in reference to the attached drawings where:

Figure 1: a schematic view of a converter on which the present disclosure applies;
Figure 2: a schematic view of a gate-control with the system of the present disclosure;

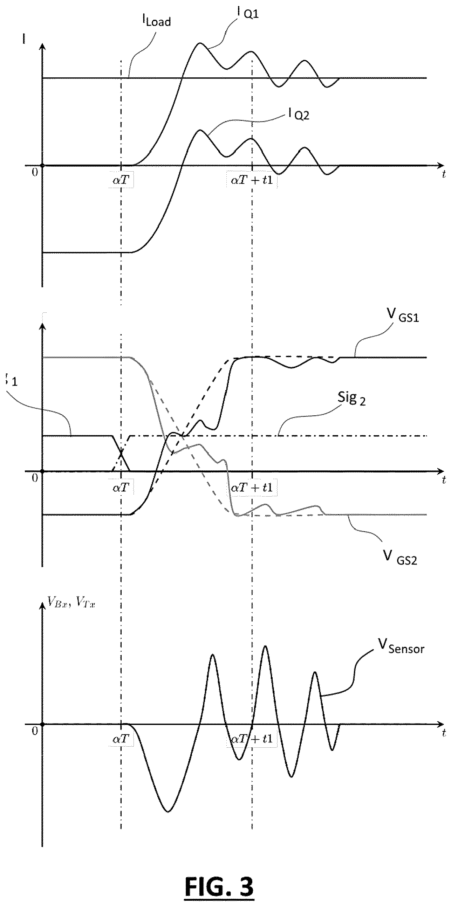

Figure 3: charts of an example of commutation in accordance with the present disclosure;
Figure 4: an example of adder and amplifier circuit of the present disclosure;
Figure 5A: a general schematic of a Rogowski coil applicable;
Figure 5B: a first embodiment of Rogowski coil of the present disclosure;
Fig 6A: a schematic view of a another embodiment of Rogowski coil of the present disclosure;
Fig 6B: a schematic view of a dual straight Rogowski coil of figure 6A.


## Detailed description of embodiments of the invention

The following description is based on a MOSFET application but can be extended to any unipolar (JFET, IGFET, HEMT) or bipolar transistor (BJT or IGBT) for which only the name of the electrodes need to be changed.

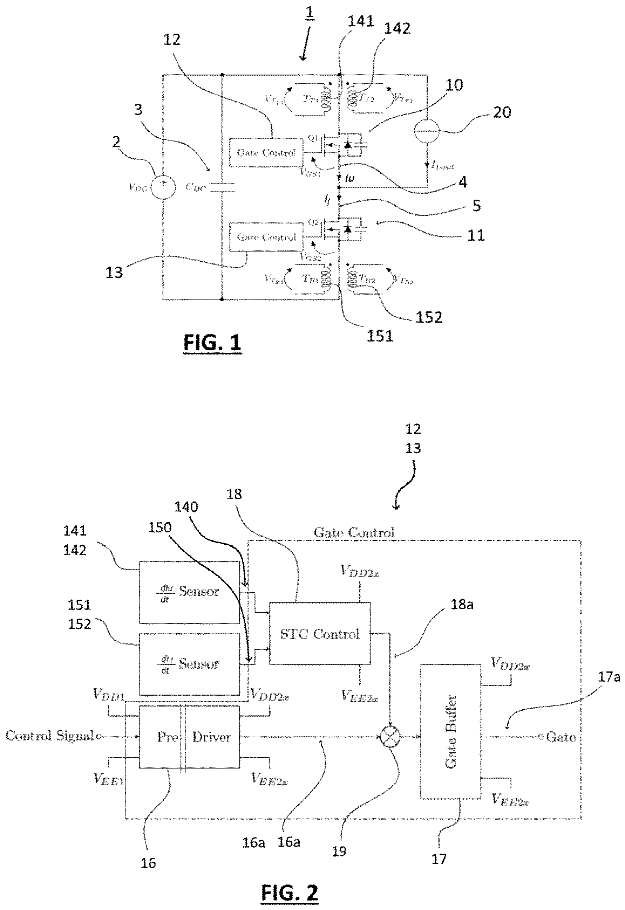

Figure 1 is a schematic view of a DC/DC converter 1 with two power switches 10, 11 in the leg of a half bridge converter having a DC voltage source 2 with capacitor 3 and where the inductive load 20 is connected in parallel with an upper power switch 10 in an upper branch 4 of the leg between the high potential $V_{DC}$ line of a DC voltage of the DC source 2 and the midpoint of the complete leg and where the lower power switch is located in a lower branch 5 of the leg between the midpoint of the complete leg and the low potential of the DC source.

The upper power switch is driven by a first gate-control circuit 12 and the lower power switch 11 is driven by a second gate-control circuit 13.

In accordance with the present disclosure two current derivative sensors 141, 142 oriented in a same direction are positioned on the upper branch conductor and two current derivative sensors 151, 152 oriented in a same direction are positioned on the lower branch 5 conductor.

The principle of the disclosure is based on:

- sensing the current derivative $\dfrac{dI_u(t)}{dt}$ and $\dfrac{dI_l(t)}{dt}$ flowing through the upper and lower branches power switches during commutation,

- adding the upper branch current derivative and the lower branch current derivative, amplifying the leg derivative current $\dfrac{dI}{dt}$ obtained,

- modulating the power device gate voltage according to $\dfrac{dI}{dt}$ sensor signals,

And complete the commutation.

Filtering the signals coming from the current derivative sensors can also be done if necessary.

This process ensures zero dead-time in the commutation and uses:

- means for sensing the current derivative flowing through each device of the switching cell;
- means for conditioning the current derivative signals coming from the sensors;
- means for modulating the power device gate voltage with the sum of these current derivative signals.

Figure 2 represents gate-control circuits 12, 13 of the present disclosure. Each of the upper branch and the lower branch has its own gate-control circuit. On each of these gate-control circuits are connected one derivative current sensor 141, 142 of the upper branch and one current derivative sensor 151, 152 of the lower branch. Each gate-control circuit comprise a pre-driver 16 with an insulating barrier between a controller input module powered by an upstream power supply $V_{DD1}$, $V_{EE1}$ and an output module powered by a downstream power supply $V_{DD2x}$, $V_{EE2x}$. The downstream power supply also powers a modulating and conditioning circuit 18 also called shoot through circuit STC receiving the derivative current sensors outputs and a gate control circuit.

The modulating and conditioning circuit 18 receives the derivative currents sensed by the upper branch and the lower branch derivative current sensors and has its output signal 18a mixed at the mixer 19 with the pre-driver 16 output signal 16a to provide the command signal 17a buffered through a gate buffer 17 connected to the gate of the power switch of the branch to which the gate-control circuit is connected.

According to the nature of the different signals, the conditioning and modulating functions are identical for the upper and lower power switches defining the switching cell. However due to the different potentials needed to command the switches, e.g. in figure 1 the upper MOSFET switch source is at a higher potential than the lower MOSFET switch source, two gate-control circuits 12, 13, each having its upper 141, 142 and lower 151, 152 sensors, pre-driver 16, modulating and conditioning circuit 18 and gate buffer 17, are needed. The current derivative sensors are also identical and a particular care on the design is required to be able to insert the sensors at the same location in the circuit to ensure same current derivative measurement for the two power devices.

The detailed operation of the invention will be done according to the following assumption and initial state with respect to figure 1 where MOSFET devices 10, 11 are considered in the switching cell, the symbol includes the intrinsic body-diode and output capacitor COSS.

The load 20 is connected between the middle point of the switching cell and the high potential of the DC voltage source 2, the load current is considered positive, meaning the current goes from the positive DC bus to the middle node of the switching cell, the load current is considered constant during the transition time scale, the upper switch Q1 10 is considered "ON", meaning that it is conducting the load current, the lower switch Q2 11 is considered "OFF", meaning that it is blocking the DC voltage and no current is flowing through it.

The description hereunder focuses the transition from Q1 conducting/Q2 blocking to Q1 blocking/Q2 conducting but applies to the inverse transition.

According to figure 1 and the Kirchhoff's current law the relation between the different currents are as in (1).

$$IQ1 + ILoad - IQ2 = 0$$

$$1)$$

The detailed description of dead-time less operation is done according to **Erreur ! Source du renvoi introuvable..** For $0 \leq t < \alpha T$ the top switch Q1 is ON and the bottom switch Q2 is OFF. The gate voltages are respectively $V_{GS1}$ in high (positive) and $V_{GS2}$ in low (negative) state. The load current $I_{Load}$ is flowing through Q1 from Source (S) to Drain (D) meaning that $I_{Q1} = -I_{Load}$. At $t = \alpha T$ complementary control signals $Sig_1$ and $Sig_2$ from the controller are sent to Q1 and Q2, in parallel nearly without any dead-time which allows having nearly simultaneous control on both switches within the limit of the tolerances of the components. The gate-source voltages $V_{GS1}$, $V_{GS2}$ of the two switches start moving with a slight delay due to propagation times. The current flowing through the switches increases with a positive current derivative because of the start of cross-conduction. The $\dfrac{dI(t)}{dt}$ sensors placed as presented in **Erreur ! Source du renvoi introuvable.** react with a negative coupling; therefore the sensor output voltages $V_{Sensor} = V_{Bx} = V_{Tx}$, where $V_{Tx}$ and $V_{Bx}$ are respectively the voltages of the upper and lower sensor, is negative. The output voltages of the upper and lower sensor are summed and amplified by the modulating and amplifying circuit 18 (shoot through circuit STC) placed in parallel of the conventional pre-driver 16. Therefore, the signal at the input of the gate buffer 17 is a combination of the pre-driver output 16a and the STC output 18a of figure 2. The two gate-source voltages are independently modulated according to the current derivative to avoid any surge current, normally present during cross-conduction and that could potentially lead to the destruction of the switching cell. The switch currents $I_{Q1}$ and $I_{Q2}$ are oscillating before reaching the steady state. Oscillations are also managed by the current derivative sensors and the STC circuit. In practice the oscillations are reduced with the proposed invention. This would apply mutatis-mutandis to the $V_{GE}$ Gate-emitter voltage of an insulated gate bipolar transistor (IGBT).

At $t = \alpha T = t1$ the commutation can be considered complete as the current $I_{Q2}$ in Q2 is almost equal to the load current and the current $I_{Q1}$ in Q1 almost equal to zero. Even if some oscillations remain the current derivative is not big enough to fully activate the STC circuit. As soon as the two currents become constant the STC circuit is no more operative until the next transition orders.

The following steps are summing-up the operation of the zero-dead time control system:

Complementary orders are sent from the Controller to the gate control circuit without any dead-time,

Q2 start conducting while Q1 is not completely OFF,

The current flowing through the top and bottom devices start rising,

The current derivative sensors sense the current derivative of the leg current,

The output voltage of the two current derivative sensors related to each power device are summed,

If it is needed a filtering stage can be applied to the coil's output voltage,

The sum of the $\dfrac{dI(t)}{dt}$ signals from coils are amplified,

The gate voltage of each device is modulated according to the $\dfrac{dI(t)}{dt}$ to control the transition current to have Q1 turn-OFF sped up and Q2 turn-ON slowed down.

When the commutation is complete Q1 is "OFF" and Q2 is "ON";

This operation procedure is the same in the case of Q2 turning OFF and Q1 turning ON.

Back to figure 2, the circuits of a gate-control 12, 13 are as follows.

The pre-driver 16 transfers the control signal from a controller to the gate node and isolates the "power circuit" from the controller part as usual in a converter. According to the driver architecture there are no particular constraints on the pre-driver's current capabilities. The pre-driver function can be fulfilled by any standard component of the art.

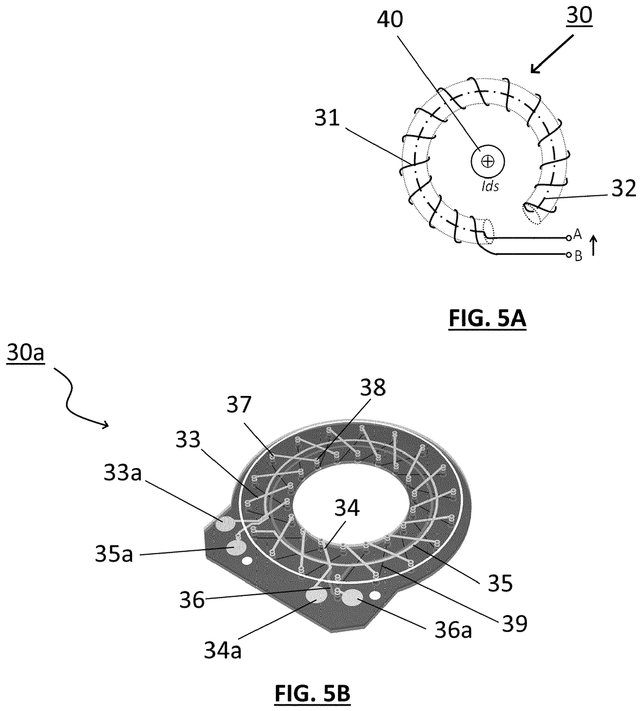

The current derivative sensors 141, 142, 151, 152 generate signals that are proportional to the time rate of change of the drain-source current of the power switches. When the current $I_{DS}$ flowing through a power device is going from a highest value to a lowest value the output signal of the corresponding sensor is positive. Conversely when the current $I_{DS}$ of the power device is going from a lowest value to a highest value the output signal of such sensor is negative. This function can be done by using Rogowski coils which are wound coils surrounding a main conductor as presented in figure 5A discussed hereunder.

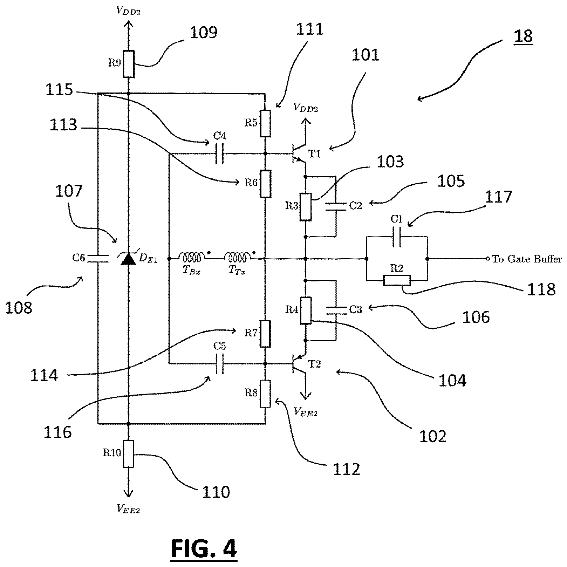

The modulating and amplifying circuit (STC circuit) of figure 2 is presented in more details in figure 4. This circuit is duplicated for the two controlled power switches and amplifies the signal coming from the derivative sensors $TB_x$ and $TT_x$, x being 1 or 2 (e.g. sensors 141 and 151 or sensors 142 and 152) respectively for switch Q1 10 and Q2 11. In the preferred implementation, the STC is composed of two transistors 101 and 102, the respective emitter of each transistor is connected to a middle point through an R-C circuit, (R3 103-C2 105 and R4 104 -C3 106). R3 103 and R4 104 are used as a negative feedback in case of a thermal drift of the transistors. C2 105 and C3 106 assure a very low impedance path for the amplified AC signal. The zener diode (DZ1) 107, the capacitor C6 108 and the resistors R9 109 -R10 110 are acting as decoupled voltage source as the value for R9-R10 are selected to be relatively high.

The resistance network composed of resistor R5 111, R8 112, R6 113 and R7 114 is implemented to polarize the two transistors 101, 102, meaning the base-emitter voltages (VBE) are close to 0.6 V. With this polarization the two transistors are at the limit of the blocking state and the linear portion. All this assembly composed of the two transistors and passive components act as a class AB amplifier, amplifying the signal from the current derivative sensors connected through the AC coupling capacitors C4 115 and C5 116. The last R-C combination formed by C1 117 and R2 118 connected between the output of the amplifier and the gate buffer can be tuned to obtain the desired gain.

Power supplies of the gate-control circuits and amplifier circuit are referenced to the bottom end voltage, or source voltage in case of a MOSFET, of the power switch they act on. Here this corresponds to the mid-point of the leg for the upper switch and the lower point of the leg for the bottom switch. Each circuit is then provided with its own $V_{DD}$ and $V_{EE}$ that is $V_{DD2x}$ and $V_{EE2x}$ with x in correspondence to the upper or the lower switch reference.

The principle disclosed for a converter having one leg with two branches 4, 5 and two switches can be extended to an unlimited number of switches as long as the total number of switches of a switching cell is pair.

With respect to the current derivative sensors a possible implementation is a Rogowski coil 30 such as schematically represented in figure 5A. Such a coil has a toroidal winding 31 and a return conductor inside the winding 32. The coil lies in a plane perpendicular to a conductor 40 to be sensed and has two output terminals A, B.

To assure that the two current derivative sensors surrounding the same conductor are sensing the same H-field a particular care is mandatory during the design process. The selected solution is to interleave the two windings, which is easy to do by designing the sensors as interleaved Rogowski coils made with a multilayer PCB, as presented in figure 5B. This configuration can be used as an external sensor.

In such implementation where the PCB has four layers, the toroidal windings of a first coil may be done through lines 33 going from an upper level to a lower level line 39 through vias 37, 38 and the return line 35 of said coil through an intermediate level, said first coil having input/output terminals 33a, 35a. The second coil may have input/output terminals 34a, 36a, a toroidal winding 34, 39 interleaved with the winding of the first coil in the first and fourth level and a return line 36 on a second intermediate level. Such a design is easy to manufacture, compact and provides a good matching of the two interleaved coils.

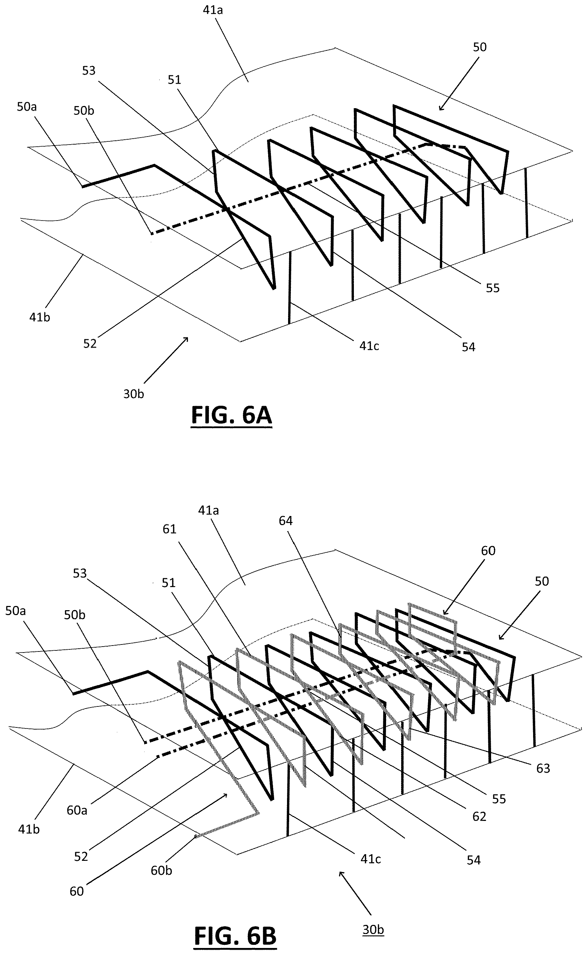

In a specific embodiment which may be used in other applications than the present converter, a reversed or straight Rogowski coil sensor is provided as presented in figure 6A, where the coil is between branches of a conductor to sense. Such coil can also be integrated in inner layers of a multilayer PCB. The coil winding is done with tracks 51 in a first layer, vias 53, 54 and tracks 52 in a second layer. The first and second layers and vias are inner tracks and vias of the PCB and the reversed Rogowski coil is sensing the current derivative flowing through surface power tracks 41a, 41b surrounding the coil and connected through 41c.

In figure 6B a double coil is designed and a second coil 6 having input output terminals 60a, 60b and second tracks 61, 62 is interleaved with the first coil tracks and connected through vias 63, 64 parallel to the first coil vias. This provides a compact design that can be directly embedded in the converter PCB or any other device PCB and that does not necessitate wiring of cables and soldering of terminals.

As stated above the present invention is not limited to the disclosed embodiment as the converter may also be of the inverter type with three legs with sensors in each leg and adding and amplifying circuit for each gate control circuit or a converter having multiple parallel switches per leg where the gate control circuits for such parallel switch are equipped with the sensing and current modulating circuits of the invention.

**Claims**

1. Switching method for a half bridge power converter comprising at least a pair of power switches (10, 11) in a leg (4, 5) of said converter providing an upper branch (4) power switch (10) and a lower branch (5) power switch (11) and comprising a first gate control circuit (12) for said upper branch power switch and a second gate control circuit (13) for said lower branch power switch, **characterized in that** said switching method comprises:

   - sensing a current derivative in said upper branch and a current derivative in said lower branch during switching of said pair of power switches to provide a first signal $(\frac{dI_u(t)}{dt})$ proportional to the current derivative of a power current in said upper power switch and a second signal $(\frac{dI_l(t)}{dt})$ proportional to the current derivative of a power current in said lower power switch,

   - summing said first and second signals to provide a summed current derivative signal $(\frac{dI(t)}{dt})$ and;
   - adding said summed current derivative signal (18a) to a power switch command signal (16a) of said first gate control circuit (12) and a power switch command signal of said second gate control circuit (13) causing the summed derivative signal to modulate gate commutation signals (17a) of said gate control circuits such that a current variation in both power switches is equalized by slowing down a commutation of a faster power switch of said pair of power switches while accelerating a commutation of a slower switch of said pair of power switches, in view to reduce dead time of commutation and control current overshoot in said switches.

2. Switching method for a half bridge power converter comprising amplifying (T1, T2) said summed current derivative signal prior to adding said summed current derivative signal to the power switch command signals.

3. Switching method for at least one pair of power switches according to claim 1 or 2 wherein sensing the current derivative in said upper branch is done with separate first (141) and second (142) upper sensors and sensing the current derivative in said lower branch is done with separate first (151) and second (152) lower sensors to provide a first summed current derivative signal to be added to the switch command signal of said first gate control circuit (12) and a second summed current derivative signal to be added to the switch command signal of said second gate control circuit (13).

4. Switching method for at least one pair of power switches according to claim 3 wherein said method comprises referencing said first summed current derivative to the voltage of the bottom end of said upper branch power switch and referencing said second summed current derivative to the voltage of the bottom end of said lower branch power switch.

5. Half bridge power converter comprising an upper power switch (10) on an upper branch (4) of the converter, said upper power switch (10) being driven by a first gate-control driver (12), and a lower power switch (11) on a lower branch (5) of the converter, said lower power switch being driven by a second gate-control driver (13), **characterized**

**in that** said gate control drivers each comprises an electronic circuit for implementing the switching method of any one of claim 1 to 4 wherein said electronic circuits comprise, for each of said upper and lower switch, at least a first current derivative sensor (141, 142) on said upper branch (4) providing a first current derivation signal (140), at least a second current derivative sensor (151, 152) on said lower branch (5) providing a second current derivation signal (150), modulating and conditioning circuit (18) for adding and amplifying said first and second current derivation signals to provide an amplified summed derivation signal (18a) and an adder (19) for adding said derivation signal to the command signals (16a) of said first and second gates drivers.

6. Half bridge power converter according to claim 5 wherein said modulating and conditioning circuits (18) are powered through power supplies ($V_{DD2x}$, $V_{EE2x}$) having a mid-point referenced to the low end voltage of the power switch they act on.

7. Half bridge power converter according to claim 5 or 6 wherein each of said modulating and conditioning circuits (18) is located before a gate buffer (17) and after a pre-driver circuit (16) part of the gate-control driver of each of the power switches.

8. Half bridge power converter according to claim 5, 6 or 7 wherein said current derivative sensors are made with Rogowski coils (30, 30a, 30b).

9. Half bridge power converter according to claim 8 wherein said Rogowski coils are annular Rogowski coils (30, 30a) located around power conductors of the power switches.

10. Half bridge power converter according to claim 9 wherein said Rogowski coils (30a) are each routed with lines (33, 35, 36, 39) in multiple layers of a multilayer PCB having a central aperture for receiving a power conductor in a direction perpendicular to said PCB.

11. Half bridge power converter according to claim 9 or 10 wherein two Rogowski coils are interleaved on the upper branch power switch power conductor (4) and/or on the lower branch power switch power conductor (4).

12. Half bridge power converter according to any one of claims 5, 6 or 7 wherein said current derivative sensors are straight Rogowski coils (30b) each routed in multiple layers of a multilayer PCB and surrounded by a power conductor track (41a, 41b, 41c) routed from an upper side to a lower side of said PCB around said planar coils in a perpendicular direction to said coils.

13. Half bridge power converter according to claim 12 wherein two straight Rogowski coils (50, 60) are interleaved on the power conductor of the upper branch power switch and/or the power conductor of the lower branch power switch are interleaved.

14. Power converter comprising two or more half bridge power converters according to any one of claims 5 to 13.

**FIG. 1**

**FIG. 2**

**FIG. 3**

## FIG. 4

40

30

31

32

$I_{ds}$

A

B

**FIG. 5A**

30a

38

37

33

33a

35a

34

36

34a

36a

39

35

**FIG. 5B**

**FIG. 6A**

**FIG. 6B**

Europäisches
Patentamt

European
Patent Office

Office européen
des brevets

# EUROPEAN SEARCH REPORT

**Application Number**

EP 20 30 5434

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | JP 2016 092884 A (DENSO CORP) 23 May 2016 (2016-05-23) | 1,2,5-14 | INV. H02M1/08 |
| A | * figures 1,4-6 * | 3,4 | H02M1/088 H03K17/16 |
| Y | WO 2018/189035 A1 (ABB SCHWEIZ AG [CH]) 18 October 2018 (2018-10-18) | 1,2,5-14 | H03K17/042 H02M1/00 |
| A | * page 11, line 33; figures 1A-C,2-4,9,10 * <br> * page 14, line 8 * | 3,4 | G01R15/18 H01F5/00 |
| Y | EP 2 741 390 A1 (SCHNEIDER ELECTRIC IND SAS [FR]) 11 June 2014 (2014-06-11) * paragraphs [0034], [0039]; figures 3,4 * | 1,2,5 | |
| Y | DE 41 11 831 A1 (ABB PATENT GMBH [DE]) 15 October 1992 (1992-10-15) * claim 5; figure 1 * | 1,5 | |
| Y | US 2005/248430 A1 (DUPRAZ JEAN-PIERRE [FR] ET AL) 10 November 2005 (2005-11-10) * paragraphs [0051], [0052], [0058], [0068]; figures 7,8 * | 2,7-13 | |

**TECHNICAL FIELDS SEARCHED (IPC)**

H02M
H03K
G01R
H01F

The present search report has been drawn up for all claims

| Place of search | Date of completion of the search | Examiner |
|---|---|---|
| The Hague | 7 September 2020 | Kanelis, Konstantin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 20 30 5434

This annex lists the patent family members relating to the patent documents cited in the above-mentioned European search report.
The members are as contained in the European Patent Office EDP file on
The European Patent Office is in no way liable for these particulars which are merely given for the purpose of information.

07-09-2020

| Patent document cited in search report | | Publication date | Patent family member(s) | | Publication date |
|---|---|---|---|---|---|
| JP 2016092884 | A | 23-05-2016 | JP | 6319045 B2 | 09-05-2018 |
| | | | JP | 2016092884 A | 23-05-2016 |
| WO 2018189035 | A1 | 18-10-2018 | EP | 3602083 A1 | 05-02-2020 |
| | | | WO | 2018189035 A1 | 18-10-2018 |
| EP 2741390 | A1 | 11-06-2014 | CN | 103852691 A | 11-06-2014 |
| | | | EP | 2741390 A1 | 11-06-2014 |
| | | | ES | 2535750 T3 | 14-05-2015 |
| | | | RU | 2013154085 A | 10-06-2015 |
| | | | UA | 118952 C2 | 10-04-2019 |
| DE 4111831 | A1 | 15-10-1992 | NONE | | |
| US 2005248430 | A1 | 10-11-2005 | AT | 355531 T | 15-03-2006 |
| | | | CN | 1783372 A | 07-06-2006 |
| | | | DE | 602005000614 T2 | 04-10-2007 |
| | | | EP | 1596205 A1 | 16-11-2005 |
| | | | ES | 2284125 T3 | 01-11-2007 |
| | | | FR | 2870040 A1 | 11-11-2005 |
| | | | JP | 4842562 B2 | 21-12-2011 |
| | | | JP | 2005322933 A | 17-11-2005 |
| | | | US | 2005248430 A1 | 10-11-2005 |

EPO FORM P0459

For more details about this annex : see Official Journal of the European Patent Office, No. 12/82